# EUROPEAN PATENT SPECIFICATION

(11) **EP 3 892 570 B1**
(45) Date of publication and mention of the grant of the patent: **17.09.2025**
(21) Application number: 18942459.1
(22) Date of filing: 06.12.2018
(51) Int. Cl.: H05K 13/08, H05K 13/02, B65G 1/10

(54) **STORAGE AND STORAGE APPARATUS PROVIDED WITH SAME**
SPEICHER UND SPEICHERVORRICHTUNG DAMIT
ÉLÉMENT DE STOCKAGE ET APPAREIL DE STOCKAGE POURVU DE CELUI-CI

(43) Date of publication of application: 13.10.2021
(73) Proprietor: Fuji Corporation, Chiryu-shi, Aichi 472-8686 (JP)
(72) Inventor: ITO Akinobu, Chiryu-shi, Aichi 472-8686 (JP)
(74) Representative: Grünecker Patent- und Rechtsanwälte PartG mbB
(86) International application number: PCT/JP2018/044898
(87) International publication number: WO 2020/115858

(56) References cited:
- EP-A1- 3 344 027
- WO-A1-2014/010083
- WO-A1-2014/142374
- WO-A1-2018/189699
- JP-A- 2012 182 246
- JP-A- H09 175 605
- US-A1- 2017 354 070

## Description

### Technical Field

The present specification describes a technology related to a storage and a storage apparatus provided with the same.

### Background art

An automatic warehouse system disclosed in Patent Literature 1 transfers an article between a crane and an unmanned conveyance vehicle in a rack. For example, the automatic warehouse system stops the unmanned conveyance vehicle at a lower position of the article that is placed on an article receiver of a warehousing work station. Next, the automatic warehouse system operates a propulsion means such as a hydraulic jack to raise a moving and placing portion of the unmanned conveyance vehicle and place the article on the moving and placing portion of the unmanned conveyance vehicle. Then, the automatic warehouse system makes the unmanned conveyance vehicle travel and delivers the article from a warehousing work station.

A reel component inventory management system disclosed in Patent Literature 2 performs an automatic search for specifying a reel component that satisfies delivery requirements and a storage location, and automatically confirms the correctness of the delivered article. Specifically, the reel component inventory management system registers the warehoused reel component and searches reel management information in response to the delivery request. Then, the reel component inventory management system specifies the reel component, and performs collation of the reel component and approval of delivery at the time of delivery.
US 2017/354070 A1 discloses a component mounting system that includes a component mounter that mounts a component in a board, a tape feeder that is placed in the component mounter and supplies the component, and a mobile component supply device that holds a tape cassette storing a component, automatically moves, and supplies the component in the tape cassette to the tape feeder.
EP 3 344 027 A1 discloses a component mounting line with an exchanging robot. WO 2014/142374 A1 discloses a SMD reel storing device a conveying part for gripping and conveying a reel fixed by a clamp.
WO 2018/189699 A1 discloses a device for the storage of reels of electronic components.
WO 2014/010083 A1 discloses a component mounting system capable of automatically replenishing parts to a plurality of mounting machine modules.
JP H09 175605 A discloses an automatic storage warehouse system.

### PATENT LITERATURE

Patent Literature 1: JP-A-H11-116006
Patent Literature 2: JP-A-2001-106308

### SUMMARY OF THE INVENTION

The invention is defined in claim 1.

Preferred embodiments are defined in the dependent claims.

### Technical Problem

However, the automatic warehouse system disclosed in Patent Literature 1 transfers the article via the warehousing work station, and does not directly transfer the article between the unmanned conveyance vehicle and the storage. Further, Patent Literature 2 does not disclose a specific aspect at the time of warehousing and delivering the reel component.

In view of such circumstances, the present specification discloses the storage that can directly transfer the article between the unmanned conveyance vehicle and the storage, and the storage apparatus having the same.

### SOLUTION TO PROBLEM

The present specification describes a storage and supply system comprising: a storage, and an unmanned conveyance vehicle configured to:convey multiple articles in a state of being accommodated in an accommodation case, and separate itself from the accommodation case to leave it within the storage so as to allow the unmanned conveyance vehicle to be separated from the storage and the accommodation case, wherein the storage comprising:an opening portion configured to be connectable with the unmanned conveyance vehicle conveying the articles to a board work machine for performing a predetermined board working on a board;a housing section configured to house the articles conveyed by the unmanned conveyance vehicle;a moving portion configured to:move the articles to a predetermined housing section at the time of warehousing the articles by connecting the unmanned conveyance vehicle to the opening portion, and move the articles housed in the housing section to the unmanned conveyance vehicle connected to the opening portion at the time of delivering the articles; and a holding portion configured to hold the accommodation case during the times of warehousing the articles and delivering the articles so as to allow the unmanned conveyance vehicle to be separated from the storage.

### ADVANTAGEOUS EFFECT OF THE INVENTION

The above-described storage includes an opening portion, a housing section, and a moving portion. Thus, in the storage, the article can be directly transferred between the unmanned conveyance vehicle and the storage in a state where the unmanned conveyance vehicle is connected to the opening portion, and the work efficiency of article loading and unloading work is improved.

### BRIEF DESCRIPTION OF DRAWINGS

Fig. 1 is a configuration view showing a configuration example of board production facility 80.
Fig. 2 is a plan view showing an example of a state in which article 22 is accommodated in accommodation case 21 at arrival unit 20.
Fig. 3A is a perspective view showing an example of accommodation case 21 capable of accommodating reel 22a.
Fig. 3B is a side view of accommodation case 21.
Fig. 4 is a side view showing an example of unmanned conveyance vehicle 30.
Fig. 5A is a front view showing an example of storage 40.
Fig. 5B is a plan view of storage 40.
Fig. 5C is a perspective view of storage 40.
Fig. 6 is a side view of storage 40 showing an example of a state in which unmanned conveyance vehicle 30 is connected to opening portion 41a.
Fig. 7 is a block view showing an example of a control block of storage 40.
Fig. 8A is a flowchart showing an example of a control procedure at the time of warehousing article 22.
Fig. 8B is a flowchart showing an example of a control procedure at the time of delivering article 22.
Fig. 9 is a sectional view taken along line IX-IX of Fig. 6.
Fig. 10 is a schematic view showing an example of a correspondence relationship between specific information and identification information.
Fig. 11 is a side view showing another example of unmanned conveyance vehicle 30.
Fig. 12 is a block view showing another example of a control block of storage 40.

### DESCRIPTION OF EMBODIMENTS

### 1. Embodiment

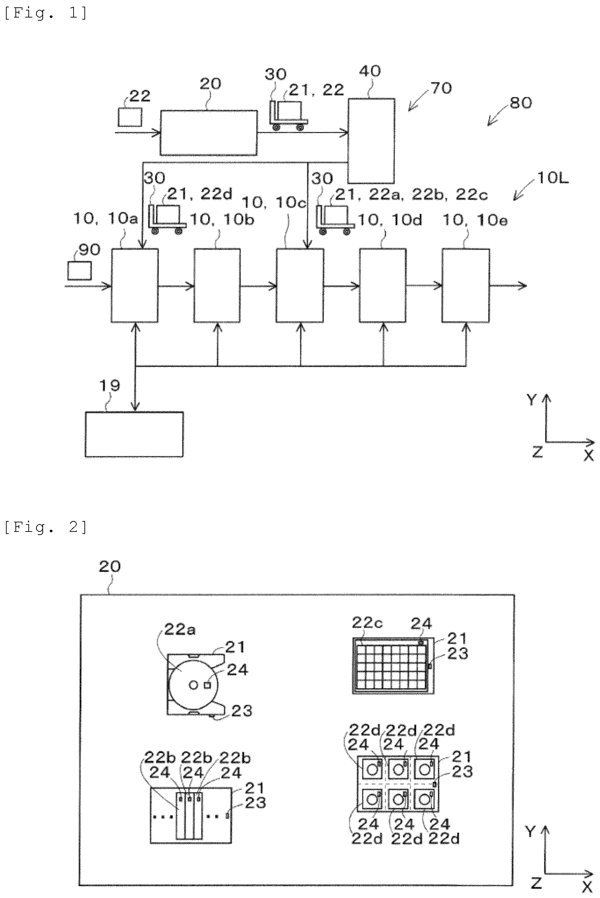

Storage 40 of the present embodiment is preferably used for storage apparatus 70, and storage 40 is preferably used for board production facility 80. As shown in Fig. 1, storage apparatus 70 includes unmanned conveyance vehicle 30 and storage 40. Board production facility 80 includes board working line 10L, arrival unit 20, and storage apparatus 70. In board production facility 80 of the present embodiment, article 22 arriving at arrival unit 20 is conveyed to storage 40 by unmanned conveyance vehicle 30. In addition, article 22 stored in storage 40 is conveyed to board working line 10L by unmanned conveyance vehicle 30.

### 1-1. Board working line 10L

In board working line 10L, a predetermined board working is performed on board 90. The type and number of board work machine 10 constituting board working line 10L are not limited. As shown in Fig. 1, board working line 10L of the present embodiment includes multiple (five) board work machines 10 of printing machine 10a, printing inspector 10b, component mounter 10c, reflow furnace 10d, and appearance inspector 10e. Multiple (five) board work machines 10 are disposed in an order of printing machine 10a, printing inspector 10b, component mounter 10c, reflow furnace 10d, and appearance inspector 10e from the upstream side. Board 90 is loaded into printing machine 10a positioned at the head of board working line 10L. Then, board 90 is conveyed to the downstream side by a board conveyance device (not shown) of board working line 10L, and is unloaded from appearance inspector 10e positioned at the end of board working line 10L.

Printing machine 10a prints a paste-like solder at the mounting position of the component on board 90. The solder printed on board 90 has a predetermined viscosity, and the solder functions as a bonding material for bonding board 90 and the component mounted on board 90. As shown in Fig. 2, solder container 22d accommodates the solder. Solder container 22d can be, for example, a bottomed tubular or tube-shaped sealable container. Printing inspector 10b inspects a printing state of the solder printed by printing machine 10a. Component mounter 10c mounts the component on the board 90 (more specifically, on the solder printed by printing machine 10a). Component mounter 10c may be one or multiple component mounters. When multiple component mounters 10c are provided, each of the multiple component mounting machines 10c can mount components on the substrate 90.

Component mounter 10c includes a component supply device (not shown) that supplies the component to be mounted on board 90. The component can be supplied, for example, by feeder 22b, tray 22c, or the like including reel 22a shown in Fig. 2. Reel 22a is wound with a component tape (carrier tape) that accommodates the component. The component tape may be paper tape or embossed tape. Reel 22a is rotatably and detachably provided on feeder 22b. A distal end portion of the component tape is pulled out to a component pickup section provided on feeder 22b, and the components are sequentially supplied. Reel 22a can supply relatively small components such as a chip component. The components are arranged on tray 22c. Tray 22c can supply relatively large components such as QFP (Quad Flat Package) and BGA (Ball Grid Array).

Reflow furnace 10d heats board 90 on which the component is mounted by component mounter 10c, melts the solder, and performs soldering. Appearance inspector 10e inspects a mounting state of the component mounted by component mounter 10c. Specifically, appearance inspector 10e recognizes the appropriateness of the component mounted on board 90, the mounting state of the component (X-axis coordinates, Y-axis coordinates, and mounting angle), and transmits them to management device 19. In this manner, board working line 10L can use multiple (five) board work machines 10 to sequentially convey board 90 and execute production process including inspection process to produce a board product.

Board working line 10L can include, for example, a functional inspector which is board work machine 10. The functional inspector inspects the function of soldered board 90 by reflow furnace 10d. In addition, for board working line 10L, a configuration of board working line 10L can be appropriately added in response to, for example, the type of board product to be produced, and the configuration can be appropriately changed. Board working line 10L may include board work machine 10 such as, for example, a buffer device, a board supplying device, a board flipping device, a shield mounting device, an adhesive application device, and an ultraviolet ray irradiation device.

Multiple (five) board work machines 10 and management device 19 constituting board working line 10L are provided so as to communicate with each other by a wired or wireless communication section (not shown). Management device 19 controls multiple (five) board work machines 10 constituting board working line 10L, and monitors an operating status of board working line 10L. Management device 19 memorizes various control data for controlling multiple (five) board work machines 10. Management device 19 transmits control data to each of multiple (five) board work machines 10. **In** addition, each of multiple (five) board work machines 10 transmits an operating status and a production status to management device 19.

### 1-2. Arrival unit 20 and unmanned conveyance vehicle 30

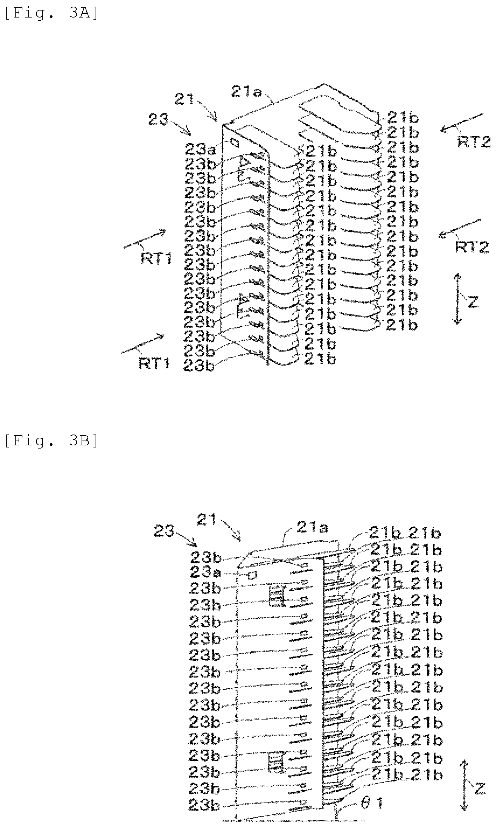

As shown in Fig. 2, arrival unit 20 includes at least one accommodation case 21. Accommodation case 21 may take various forms as long as it can accommodate at least one article 22. For example, when article 22 is reel 22a, accommodation case 21 preferably includes main body portion 21a and partition portion 21b, as shown in Fig. 3A and Fig. 3B.

Main body portion 21a is formed in an U shape when viewed in a vertical direction (Z-axis direction). Partition portion 21b is provided so as to project upward from main body portion 21a at predetermined angle θ1, and can accommodate reel 22a. Angle θ1 is set such that dropping of reel 22a can be suppressed. Angle θ1 can be set to, for example, 5° to 30°, and angle θ1 is preferably set to 10°. Partition portions 21b of the present embodiment are provided with multiple pairs (15 pairs of 30 units in Fig. 3A and Fig. 3B), and can accommodate multiple (15 units) reels 22a. Further, each of the multiple pairs (15 pairs) of partition portions 21b is provided with two partition portions 21b separated from each other so as not to interfere with moving device 40b of storage 40 described later.

Specific code 23 is provided in accommodation case 21. Specific code 23 memorizes specific information that specifies accommodation case 21. Specific code 23 includes first specific code 23a and second specific code 23b. First specific code 23a is provided in main body portion 21a, and first specific code 23a memorizes the specific information for specifying one accommodation case 21 from multiple accommodation cases 21. Second specific code 23b is provided in main body portion 21a in the vicinity of each of the multiple pairs (15 pairs in Fig. 3A and Fig. 3B) of partition portions 21b, and second specific code 23b memorizes specific information for specifying one accommodation location from the multiple (15 pairs) accommodation locations (15 pairs of partition portion 21b) of one accommodation case 21. The specific information memorized in second specific code 23b includes the specific information memorized in first specific code 23a. Specific code 23 may be, for example, an one-dimensional code, a two-dimensional code, a wireless tag, or the like.

Article 22 is stored in storage 40 and then supplied to board working line 10L as needed. As described above, board working line 10L is equipped with printing machine 10a that prints the paste-like solder at the mounting position of the component on board 90. In this case, article 22 may be, for example, solder container 22d that accommodates the solder. In addition, board working line 10L includes component mounter 10c for mounting components to board 90. In this case, article 22 may be reel 22a on which the component tape accommodating the component is wound. Article 22 may be feeder 22b on which reel 22a is rotatably and detachably provided. Further, article 22 may be tray 22c in which components are arranged. Article 22 may be a holding member (not shown) that holds the components. The holding member includes, for example, a suction nozzle, a chuck, and the like. Furthermore, article 22 may be a holding member accommodation device (not shown) that accommodates the holding member.

Article 22 is provided with identification code 24. Identification code 24 memorizes identification information for identifying article 22. As identification code 24, for example, an one-dimensional code, a two-dimensional code, a wireless tag, or the like can be used. When article 22 arrives at arrival unit 20, an operator of arrival unit 20 issues the identification information using, for example, an article management device (not shown). In addition, an operator reads a barcode or the like attached to article 22 by a supplier (vendor) using a barcode reader or the like. The operator can also obtain article information of article 22 from a database (not shown) in which the article information related to article 22 is registered. The operator causes identification code 24 to memorize the identification information and the article information using the article management device.

The operator of arrival unit 20 attaches at least identification code 24 in which the identification information is memorized to article 22, and accommodates article 22 in accommodation case 21. At this time, the operator may read second specific code 23b provided in an accommodation location for accommodating article 22 using a reader, and read identification code 24 provided in article 22 using the reader. As a result, a correspondence relationship between the specific information specifying one accommodation location for accommodating article 22 (one pair of partition portions 21b among 15 pairs of partition portions 21b) and the identification information identifying article 22 is generated, and the correspondence relationship is memorized in memory section 50 described later.

Fig. 2 shows an example of a state in which reel 22a, which is article 22, is accommodated in accommodation case 21. In addition, Fig. 2 shows an example of a state in which feeder 22b, which is article 22, is accommodated in accommodation case 21. Further, Fig. 2 shows an example of a state in which tray 22c, which is article 22, is accommodated (stacked) in accommodation case 21. Tray 22c is stored in a packaging bag, and identification code 24 is attached to the packaging bag of tray 22c. In addition, Fig. 2 shows an example of a state in which solder container 22d, which is article 22, is accommodated in accommodation case 21. It should be noted that Fig. 2 is a plan view schematically showing an example of the accommodation state of article 22. Furthermore, the present specification mainly describes a case where article 22 is reel 22a.

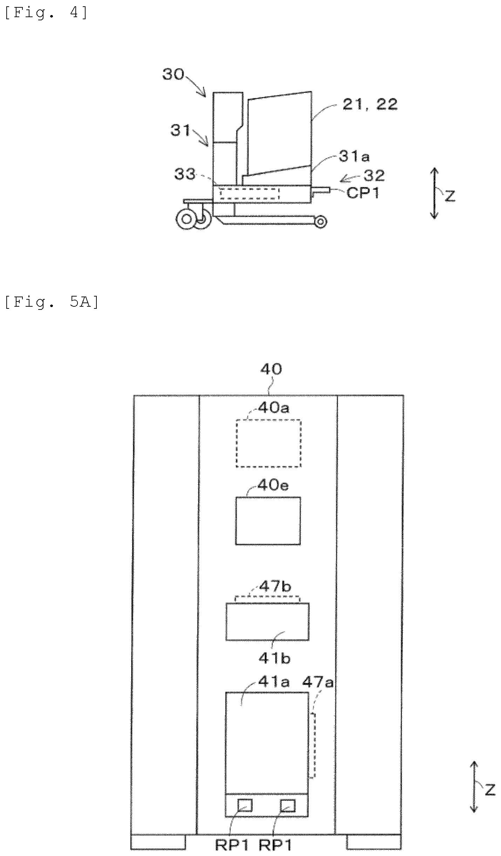

The operator of arrival unit 20 mounts accommodation case 21 in which article 22 is accommodated on unmanned conveyance vehicle 30. Unmanned conveyance vehicle 30 is an automatic guided vehicle (AGV) without requiring driving operation by the operator. Unmanned conveyance vehicle 30 may take various forms as long as it can automatically travel and convey article 22. As shown in Fig. 4, unmanned conveyance vehicle 30 of the present embodiment includes carriage portion 31 on which article 22 is mounted, and carriage portion 31 includes supporting portion 31a. Supporting portion 31a supports accommodation case 21 so that main body portion 21a of accommodation case 21 rises in the vertical direction (the Z-axis direction). In this manner, unmanned conveyance vehicle 30 of the present embodiment can convey reel 22a, which is article 22, in a state accommodated in accommodation case 21.

It should be noted that unmanned conveyance vehicle 30 can convey article 22 without using accommodation case 21. In addition, at least a part of the work performed by the operator described above can be automated using a conveyance device (for example, a belt conveyor and the like), an actuator (for example, a robot arm and the like), an article management device, and the like. In addition, board working line 10L, arrival unit 20, unmanned conveyance vehicle 30, and storage 40 are provided so as to be able to communicate with each other by a wired or wireless communication section (not shown). When article 22 is mounted on unmanned conveyance vehicle 30, management device 19 transmits a conveyance command to unmanned conveyance vehicle 30. The conveyance command includes a conveyance destination of article 22. Management device 19 selects storage 40 in which article 22 can be housed, and determines the conveyance destination. When unmanned conveyance vehicle 30 receives the conveyance command, the unmanned conveyance vehicle 30 conveys article 22 to storage 40 designated as the conveyance destination.

### 1-3. Storage 40, memory section 50, and selecting section 60

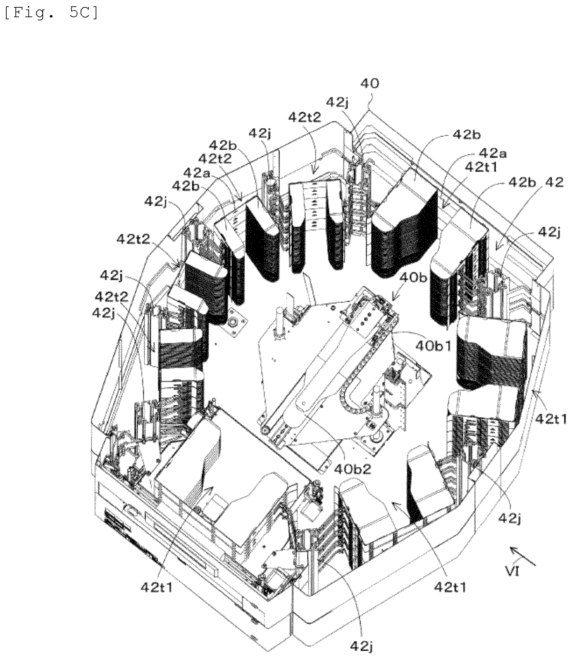

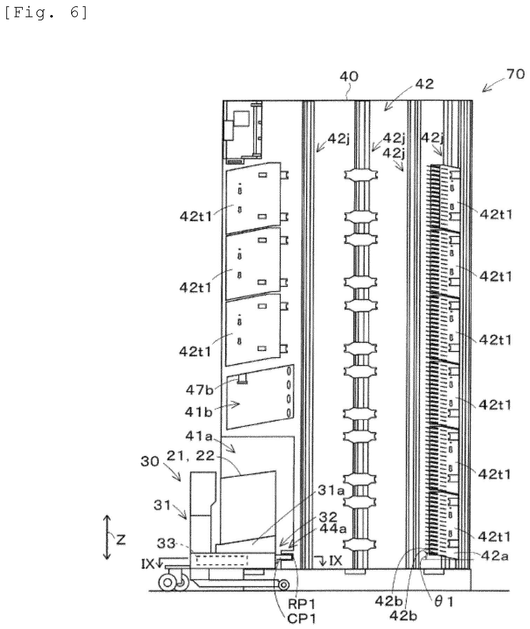

Storage 40 may take various forms as long as unmanned conveyance vehicle 30 can be connected to opening portion 41a. As shown in Figs. 5A to 5C, storage 40 of the present embodiment is formed in, for example, an octagonal prism shape. Fig. 6 shows an example of a state in which unmanned conveyance vehicle 30 is connected to opening portion 41a. Fig. 5C is a perspective view showing a state of the inside of storage 40 in which an upper portion of storage 40 is opened. Fig. 6 is a schematic view of the inside of storage 40 viewed in a direction of arrow VI shown in Fig. 5C, and mainly shows a positional relationship among unmanned conveyance vehicle 30, opening portion 41a, and a housing unit (first housing unit 42 t1 in Fig. 5C).

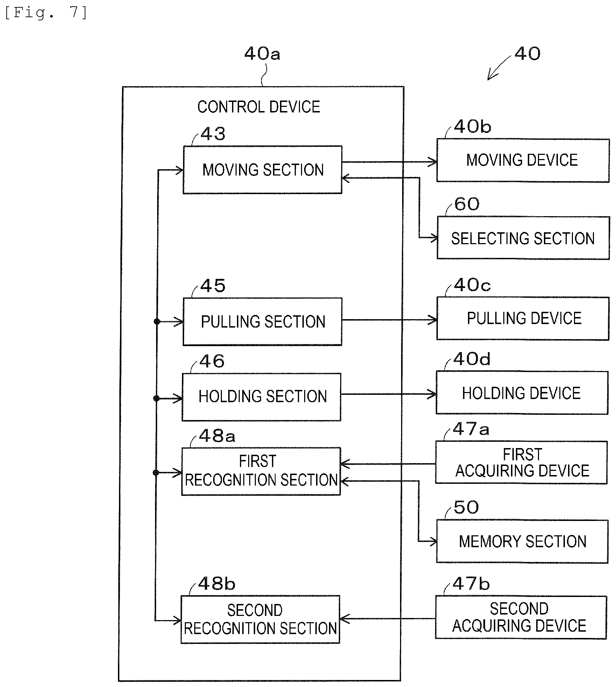

Storage 40 includes opening portion 41a, housing section 42, control device 40a, and moving device 40b. As shown in Fig. 7, control device 40a includes moving section 43 when viewed as a control block. Storage 40 preferably includes selecting section 60. **In** addition, storage 40 preferably includes first positioning portion 44a. Storage 40 preferably includes pulling device 40c, and control device 40a preferably includes pulling section 45. Storage 40 preferably includes holding device 40d, and control device 40a preferably includes holding section 46. Storage 40 preferably includes first acquisition device 47a and memory section 50, and control device 40a preferably includes first recognition section 48a. Storage 40 preferably includes second acquisition device 47b, and control device 40a preferably includes second recognition section 48b. Further, storage 40 preferably includes at least one of opening portion 41b and display device 40e. As shown in Fig. 5A to Fig. 5C, 6, and 7, storage 40 of the present embodiment includes all of the above-described portion and device.

### 1-3-1. connecting example of unmanned conveyance vehicle 30 and opening portion 41a

As shown in Fig. 5A and Fig. 6, opening portion 41a is provided so as to be connected to unmanned conveyance vehicle 30. Specifically, as shown in Fig. 6, storage 40 includes first positioning portion 44a for positioning unmanned conveyance vehicle 30 in opening portion 41a. As shown in Fig. 4 and Fig. 6, unmanned conveyance vehicle 30 of the present embodiment includes carriage portion 31, positioned portion 32, and control section 33. As described above, carriage portion 31 is a portion where article 22 is mounted, and in the present embodiment, accommodation case 21 in which article 22 is accommodated is supported by supporting portion 31a, so that article 22 is mounted on carriage portion 31.

Positioned portion 32 refers to a portion to be positioned by first positioning portion 44a. At this time, one of first positioning portion 44a and positioned portion 32 preferably includes convex portion CP1, and the other of first positioning portion 44a and positioned portion 32 preferably includes concave portion RP1. Convex portion CP1 refers to a portion formed in a convex shape. Concave portion RP1 refers to a portion that can be fitted into convex portion CP1 and is formed in a concave shape. As shown in Fig. 6, in the present embodiment, first positioning portion 44a includes concave portion RP1, and positioned portion 32 includes convex portion CP1. Convex portion CP1 and concave portion RP1 are fitted to each other so that positioned portion 32 is positioned by first positioning portion 44a. Accordingly, positioning between first positioning portion 44a and positioned portion 32 is facilitated.

Control section 33 controls traveling of unmanned conveyance vehicle 30 such that positioned portion 32 is directed to first positioning portion 44a. Control section 33 can, for example, detect a traveling path to be traveled by unmanned conveyance vehicle 30 by a detection device, and control the traveling of unmanned conveyance vehicle 30 based on a detection result. In addition, control section 33 can recognize first positioning portion 44a of opening portion 41a by, for example, a camera or the like, and control the traveling of unmanned conveyance vehicle 30 based on the recognition result.

Storage 40 of the present embodiment includes first positioning portion 44a for positioning unmanned conveyance vehicle 30 in opening portion 41a. **In** addition, unmanned conveyance vehicle 30 includes positioned portion 32 to be positioned by first positioning portion 44a, and control section 33 that controls the traveling of unmanned conveyance vehicle 30 such that positioned portion 32 is directed to first positioning portion 44a. Accordingly, unmanned conveyance vehicle 30 can be connected to opening portion 41a by independently moving.

### 1-3-2. Configuration example of housing section 42 and control device 40a

Housing section 42 houses article 22 conveyed by unmanned conveyance vehicle 30. Housing section 42 may take various forms as long as it can house article 22. For example, when article 22 is reel 22a, as shown in Fig. 5C and Fig. 6, housing section 42 preferably includes main body portion 42a and partition portion 42b. Main body portion 42a is formed in an U shape when viewed in the vertical direction (Z-axis direction). Partition portion 42b is provided so as to project upward from main body portion 42a at predetermined angle θ1, and can accommodate reel 22a. Angle θ1 is set such that dropping of reel 22a can be suppressed. Angle θ1 of partition portion 42b of housing section 42 is preferably set to the same angle as angle θ1 of partition portion 21b of accommodation case 21.

**In** addition, partition portions 42b of the present embodiment are provided with multiple pairs (15 pairs of 30 units in Fig. 6), and can accommodate multiple (15 units) reels 22a. Each of the multiple pairs (15 pairs) of partition portions 42b is provided with two partition portions 42b separated from each other so as not to interfere with moving device 40b. As described above, housing section 42 is preferably formed in the same manner as accommodation case 21. **In** Fig. 5C and Fig. 6, for convenience of illustration, some members are assigned with reference symbols, and not all members are assigned with reference symbols.

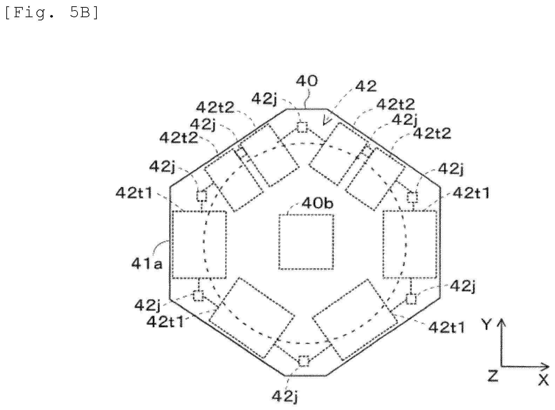

As shown in Fig. 5B and Fig. 5C, housing section 42 of the present embodiment is disposed in a circular shape when viewed in the vertical direction (Z-axis direction). In addition, housing section 42 of the present embodiment includes first housing unit 42t1 and second housing unit 42t2, and each of first housing unit 42t1 and second housing unit 42t2 is provided in multiple units along the vertical direction (the Z-axis direction). First housing unit 42t1 is formed wider than second housing unit 42t2, and can house large-sized reel 22a as compared with reel 22a capable of housing second housing unit 42t2.

As shown in Fig. 5C and Fig. 6, first housing unit 42t1 is connected in the vertical direction (the Z-axis direction) by connecting portion 42j. In addition, second housing unit 42t2 is connected in the vertical direction (the Z-axis direction) by connecting portion 42j. In addition, first housing units 42t1 adjacent to each other are connected by connecting portion 42j, and second housing units 42t2 adjacent to each other are connected by connecting portion 42j. In addition, first housing unit 42t1 and second housing unit 42t2 adjacent to each other are connected by connecting portion 42j. The type, number, and disposition of the housing units can be appropriately changed. In addition, the shape and size (width, depth, and height) of the housing unit can be set according to article 22 to be housed, and housing section 42 can house article 22 other than reel 22a. Further, article 22 may be housed in any compatible housing unit, and when board production facility 80 includes multiple storages 40, article 22 may be stored in any storage 40 as long as it is storage 40 having compatible housing unit.

Control device 40a includes a known central arithmetic unit and memory device, and a control circuit is configured therein (all of which are not shown). The central arithmetic unit is a central processing unit (CPU) and can perform various calculation processing. The memory device includes first memory device and second memory device. The first memory device is a volatile memory device (RAM: Random Access Memory), and the second memory device is a non-volatile memory device (ROM: Read Only Memory).

Control device 40a is provided so as to be capable of communicating with moving device 40b, pulling device 40c, holding device 40d, display device 40e, first acquisition device 47a, second acquisition device 47b, memory section 50, and selecting section 60, and can control them. In addition, control device 40a can memorize article information related to article 22, and can also notify management device 19 of the article information. For example, when article 22 is reel 22a, the article information may include a component type, a number of components (remaining number), a reel diameter, a type, a supplier (vendor), an expiration date, and the like of the component accommodated in reel 22a.

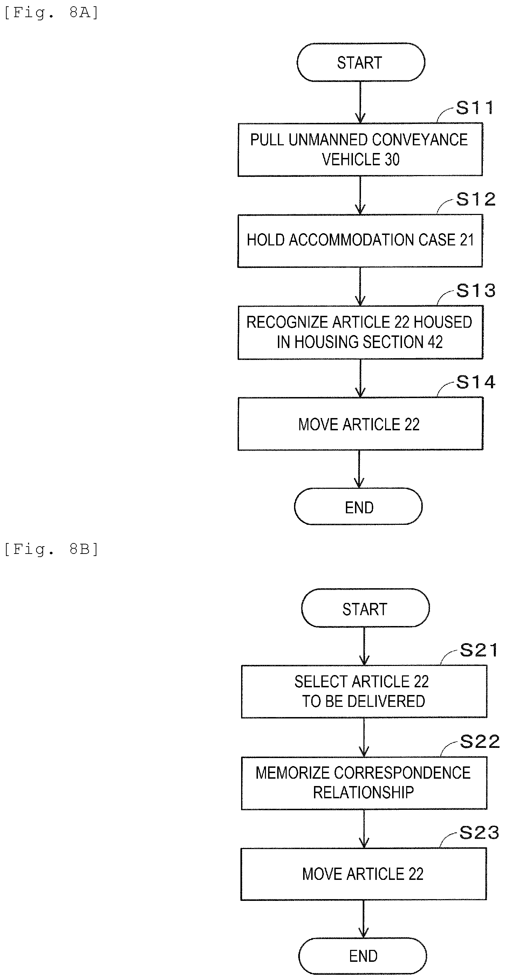

As shown in Fig. 7, when viewed as the control block, control device 40a includes moving section 43, pulling section 45, holding section 46, first recognition section 48a, and second recognition section 48b. In addition, control device 40a executes a control program according to the flowcharts shown in Fig. 8A and Fig. 8B. Fig. 8A shows an example of a control procedure at the time of warehousing article 22, and Fig. 8B shows an example of a control procedure at the time of delivering article 22.

### 1-3-3. Example of control at the time of warehousing article 22

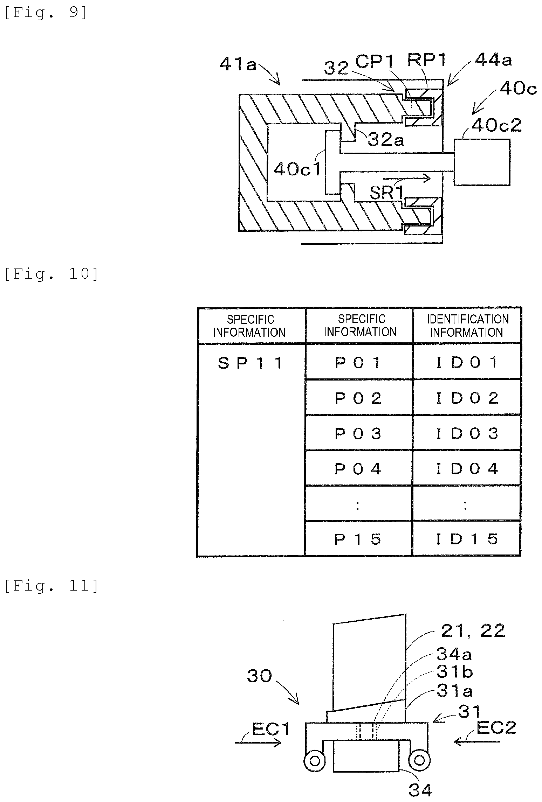

When unmanned conveyance vehicle 30 for conveying article 22 enters opening portion 41a, pulling section 45 pulls unmanned conveyance vehicle 30 to assist the positioning of unmanned conveyance vehicle 30 (step S11 shown in Fig. 8A). For example, as shown in Fig. 9, pulling section 45 can pull unmanned conveyance vehicle 30 using pulling device 40c when unmanned conveyance vehicle 30 enters opening portion 41a. Pulling device 40c preferably includes abutting section 40c1 and sliding portion 40c2. Abutting portion 40c1 is provided so as to be able to abut protruding portion 32a provided on positioned portion 32. Sliding portion 40c2 slides abutting portion 40c1 such that positioned portion 32 is directed toward first positioning portion 44a in a state where abutting portion 40c1 abuts protruding portion 32a. Pulling device 40c can use, for example, a cylinder mechanism that is driven to expand and contract by oil pressure, air pressure, electric power, or the like. In Fig. 9, the sliding direction of abutting portion 40c1 is shown by arrow SR1.

As described above, in the present embodiment, first positioning portion 44a includes concave portion RP1, and positioned portion 32 includes convex portion CP1. Then, convex portion CP1 and concave portion RP1 are fitted to each other, so that positioned portion 32 is positioned by first positioning portion 44a. As shown in Fig. 9, also in this aspect, pulling section 45 can pull unmanned conveyance vehicle 30 to assist the positioning of unmanned conveyance vehicle 30. Storage 40 of the present embodiment includes pulling section 45 that pulls unmanned conveyance vehicle 30 to assist the positioning of unmanned conveyance vehicle 30. Accordingly, the positioning of unmanned conveyance vehicle 30 is facilitated, so that connection between unmanned conveyance vehicle 30 and opening portion 41a is facilitated.

When unmanned conveyance vehicle 30 is positioned and connected to opening portion 41a, holding section 46 holds accommodation case 21 accommodating article 22 so as to allow unmanned conveyance vehicle 30 to be separated from storage 40 (step S12 shown in Fig. 8A). For example, holding section 46 can hold accommodation case 21 accommodating article 22 using holding device 40d when unmanned conveyance vehicle 30 is connected to opening portion 41a. holding device 40d can use, for example, a cylinder mechanism that is driven to expand and contract by oil pressure, air pressure, electric power, or the like. The cylinder mechanism includes at least a pair of cylinders. One of the pairs of cylinders moves in the direction indicated by arrow RT1 in Fig. 3A when holding accommodation case 21, and the other of the pair of cylinders moves in the direction indicated by arrow RT2 in Fig. 3A when holding accommodation case 21.

In unmanned conveyance vehicle 30 of the present embodiment, accommodation case 21 is supported by supporting portion 31a. Therefore, even when accommodation case 21 is held by holding section 46 in the state shown in Fig. 6 (the state in which unmanned conveyance vehicle 30 is connected to opening portion 41a), supporting portion 31a becomes an obstacle so that unmanned conveyance vehicle 30 cannot be separated from storage 40. Accordingly, carriage portion 31 preferably includes, for example, a lifting and lowering mechanism for lowering supporting portion 31a in the vertical direction (the Z-axis direction). As a result, at least a part of supporting portion 31a is housed in the inside of carriage portion 31, so that unmanned conveyance vehicle 30 can be separated from storage 40. **In** addition, holding device 40d may also include the lifting and lowering mechanism for lifting accommodation case 21 in the vertical direction (the Z-axis direction) after holding accommodation case 21. As a result, accommodation case 21 and supporting portion 31a do not interfere with each other, so that unmanned conveyance vehicle 30 can be separated from storage 40.

Unmanned conveyance vehicle 30 of the present embodiment conveys article 22 in a state where article 22 is accommodated in accommodation case 21. In addition, storage 40 includes holding section 46 that holds accommodation case 21 accommodating article 22 after unmanned conveyance vehicle 30 is connected to opening portion 41a to allow unmanned conveyance vehicle 30 to be separated from storage 40. Accordingly, unmanned conveyance vehicle 30 of the present embodiment can convey other articles 22 after accommodation case 21 is conveyed to storage 40, so that unmanned conveyance vehicle 30 can be further utilized in comparison with a case where unmanned conveyance vehicle 30 waits in storage 40.

Next, first recognition section 48a recognizes article 22 housed in housing section 42 (step S13 shown in Fig. 8A). For example, first recognition section 48a can recognize article 22 housed in housing section 42 using memory section 50 and first acquisition device 47a. Memory section 50 memorizes a correspondence relationship between the specific information for specifying accommodation case 21 accommodating article 22 and the identification information for identifying article 22. Memory section 50 can be provided in a non-volatile memory device (not shown). Fig. 10 shows an example of the correspondence relationship between the specific information and the identification information. Specifically, Fig. 10 shows that article 22 identified by identification information ID01 to identification information ID15 is accommodated in accommodation case 21 specified by specific information SP11.

In addition, Fig. 10 shows that article 22 identified by identification information ID01 is accommodated in the accommodation location specified by specific information P01, and article 22 identified by identification information ID02 is accommodated in the accommodation location specified by specific information P02. The above description can be similarly applied to articles 22 accommodated in the accommodation location specified by specific information P03 to specific information P15, respectively. As described above, in the present embodiment, when the operator of arrival unit 20 accommodates article 22 in accommodation case 21, the correspondence relationship between the specific information and the identification information is generated, and the correspondence relationship is memorized in memory section 50.

First acquisition device 47a acquires the specific information for specifying accommodation case 21 by reading specific code 23 provided in accommodation case 21. Specifically, first acquisition device 47a is provided in opening portion 41a, and acquires the specific information by reading specific code 23 provided in accommodation case 21 in a state where unmanned conveyance vehicle 30 is connected to opening portion 41a. As first acquisition device 47a, a known reader (for example, a code reader that reads an one-dimensional code, a two-dimensional code, a wireless reader that performs wireless communication with a wireless tag, or the like) can be used. First acquisition device 47a can read first specific code 23a to acquire specific information (specific information SP11 in the example shown in Fig. 10) for specifying one accommodation case 21 from multiple accommodation cases 21. In addition, first acquisition device 47a can read at least one second specific code 23b instead of first specific code 23a, and acquire the specific information (specific information SP11) for specifying one accommodation case 21 from specific information (specific information P01 to specific information P15 in the example shown in Fig. 10) for specifying one accommodation location (pair of partition portions 21b).

First recognition section 48a acquires the identification information corresponding to the specific information acquired by first acquisition device 47a from the correspondence relationship memorized in memory section 50 at the time of warehousing article 22, and recognizes article 22 housed in housing section 42 based on the identification information acquired from the correspondence relationship. For example, in the example shown in Fig. 10, first recognition section 48a acquires the identification information ID01 to identification information ID15 corresponding to specific information SP11 acquired by first acquisition device 47a from the correspondence relationship memorized in memory section 50 at the time of warehousing article 22. Then, for example, when housing article 22 accommodated in the accommodation location specified by specific information P01 in housing section 42, first recognition section 48a acquires identification information ID01 of article 22 from the correspondence relationship. As a result, first recognition section 48a can recognize that article 22 housed in housing section 42 is article 22 identified by identification information ID01. The above description can be similarly applied to articles 22 accommodated in the accommodation location specified by specific information P02 to specific information P15, respectively.

Unmanned conveyance vehicle 30 of the present embodiment conveys article 22 in a state where article 22 is accommodated in accommodation case 21, and storage 40 includes first acquisition device 47a and first recognition section 48a. First acquisition device 47a acquires the specific information for specifying accommodation case 21 by reading specific code 23 provided in accommodation case 21. First recognition section 48a acquires the identification information corresponding to the specific information acquired by first acquisition device 47a from the correspondence relationship memorized in memory section 50 at the time of warehousing article 22, and recognizes article 22 housed in housing section 42 based on the identification information acquired from the correspondence relationship. Accordingly, storage 40 of the present embodiment can simplify a recognizing work of article 22 housed in housing section 42 as compared with a case where identification code 24 provided on article 22 accommodated in accommodation case 21 is sequentially read to recognize article 22.

For example, in board work machine 10, a part of article 22 (for example, some components accommodated in reel 22a) may be used and returned to storage 40. **In** this case, in the same manner as the operator of arrival unit 20, when the operator of board work machine 10 accommodates article 22 in accommodation case 21, the correspondence relationship between the specific information and the identification information can be generated, and the correspondence relationship can be memorized in memory section 50.

In addition, when the above-described correspondence relationship is not generated and memorized, second recognition section 48b may recognize article 22 housed in housing section 42 (step S13 shown in Fig. 8A). For example, second recognition section 48b can recognize article 22 housed in housing section 42 using second acquisition device 47b. Second acquisition device 47b acquires the identification information for identifying article 22 by reading identification code 24 provided on article 22. Specifically, second acquisition device 47b is provided in opening portion 41b, so that moving device 40b described later moves article 22 mounted on unmanned conveyance vehicle 30 to opening portion 41b. As second acquisition device 47b, a known reader (for example, a code reader that reads an one-dimensional code, a two-dimensional code, a wireless reader that performs wireless communication with a wireless tag, or the like) can be used. Second acquisition device 47b acquires the identification information for identifying article 22 by reading identification code 24 provided on article 22. Second recognition section 48b recognizes article 22 housed in housing section 42 based on the identification information acquired by second acquisition device 47b at the time of warehousing article 22.

Storage 40 includes second acquisition device 47b that reads identification code 24 provided on article 22 to acquire the identification information for identifying article 22, and second recognition section 48b that recognizes article 22 housed in housing section 42 based on the identification information acquired by second acquisition device 47b at the time of warehousing article 22. Accordingly, storage 40 does not require the generation and memory of the correspondence relationship between the specific information for specifying accommodation case 21 accommodating article 22 and the identification information for identifying article 22. **In** addition, storage 40 can recognize article 22 housed in housing section 42 even when article 22 is directly mounted on unmanned conveyance vehicle 30 (when accommodation case 21 is not used).

Next, moving section 43 moves article 22 to a predetermined housing section 42 when unmanned conveyance vehicle 30 is connected to opening portion 41a and article 22 is warehoused (step S14 shown in Fig. 8A). For example, moving section 43 moves article 22 by using moving device 40b. Moving device 40b is preferably provided inside the housing unit (first housing unit 42t1 and second housing unit 42t2) when viewed in the vertical direction (the Z-axis direction). Moving device 40b may take various forms as long as it can move article 22. For example, the robot arm (an articulated robot), the lifting and lowering slide mechanism, and the like can be used for moving device 40b. For example, when article 22 is reel 22a, as shown in Fig. 5C, moving device 40b preferably includes lifting and lowering section 40b1 and gripping portion 40b2.

Lifting and lowering section 40b1 lifts and lowers gripping portion 40b2 along the vertical direction (Z-axis direction) in a state where it is rotated by a predetermined angle around an axial line along the vertical direction (Z-axis direction). Gripping portion 40b2 can advance and retreat at the same angle as angle θ1 of partition portion 21b of accommodation case 21 (angle 81 of partition portion 42b of housing section 42). Specifically, lifting and lowering section 40b1 lifts and lowers gripping portion 40b2 along the vertical direction (the Z-axis direction) such that gripping portion 40b2 reaches desired reel 22a when gripping portion 40b2 advances. Next, gripping portion 40b2 advances to grip reel 22a, and retreats in a state where reel 22a is gripped (unloading work at the time of warehousing).

Then, lifting and lowering section 40b1 rotates by a predetermined angle such that gripping portion 40b2 reaches a desired housing location (a pair of partition portions 42b of first housing unit 42t1 or second housing unit 42t2) when gripping portion 40b2 advances, so as to lift and lower gripping portion 40b2 along the vertical direction (the Z-axis direction). Next,gripping portion 40b2 advances to insert reel 22a into the housing location (the pair of partition portions 42b), releases gripping of reel 22a, and retreats (housing work at the time of warehousing).

### 1-3-4. Example of control at the time of delivering article 22

Selecting section 60 selects article 22 to be delivered from storage 40 to unmanned conveyance vehicle 30 in accordance with article 22 required by board work machine 10 (step S21 shown in Fig. 8B). Selecting section 60 can be provided in various arithmetic units (not shown). Further, for example, in accordance with an occurrence of a changeover in board work machine 10, an occurrence of a shortage of articles 22 supplied to board work machine 10, or an occurrence of a possibility of the changeover or the shortage of article 22, articles 22 required by board work machine 10 are determined. Selecting section 60 can select article 22 required by board work machine 10 from among article 22 stored in storage 40.

Next, memory section 50 memorizes the correspondence relationship between the specific information acquired by first acquisition device 47a at the time of delivering article 22 and the identification information for identifying article 22 accommodated in accommodation case 21 (step S22 shown in Fig. 8B). As described above, first acquisition device 47a acquires the specific information by reading specific code 23 provided in accommodation case 21. In addition, article 22 accommodated in accommodation case 21 (article 22 selected by selecting section 60 in the present embodiment) is already recognized by first recognition section 48a or second recognition section 48b when housed in housing section 42. Accordingly, memory section 50 can memorize the same correspondence relationship as the correspondence relationship shown in Fig. 10. When accommodation case 21 is not present in opening portion 41a, control device 40a of storage 40 requests management device 19 to convey accommodation case 21. The same applies when unmanned conveyance vehicle 30 is not connected to opening portion 41a, and control device 40a of storage 40 requests management device 19 to make unmanned conveyance vehicle 30 deliver.

Next, moving section 43 moves article 22 housed in housing section 42 to unmanned conveyance vehicle 30 connected to opening portion 41a (step S23 shown in Fig. 8B). For example, moving section 43 moves article 22 using above-described moving device 40b. Specifically, lifting and lowering section 40b1 lifts and lowers gripping portion 40b2 along the vertical direction (the Z-axis direction) such that gripping portion 40b2 reaches reel 22a housed in the desired housing location (the pair of partition portions 42b) when gripping portion 40b2 advances. Next, gripping portion 40b2 advances to grip reel 22a housed in the housing location (the pair of partition portions 42b), and retreats in a state where reel 22a is gripped (unloading work at the time of delivering).

Then, lifting and lowering section 40b1 rotates by the predetermined angle such that gripping portion 40b2 reaches the desired accommodation location of accommodation case 21 (the pair of partition portions 21b) when gripping portion 40b2 advances, so as to lift and lower gripping portion 40b2 along the vertical direction (the Z-axis direction). Next, gripping portion 40b2 advances to insert reel 22a into the accommodation location (the pair of partition portions 21b), releases gripping of reel 22a, and retreats (accommodating work at the time of delivering).

Moving section 43 of the present embodiment moves article 22 selected by selecting section 60 to unmanned conveyance vehicle 30. Accordingly, storage 40 of the present embodiment can easily deliver articles 22 required by board work machine 10. **In** the present embodiment, memory section 50 memorizes the correspondence relationship between the specific information acquired by first acquisition device 47a at the time of delivering article 22 and the identification information for identifying article 22 accommodated in accommodation case 21. Accordingly, storage 40 of the present embodiment can easily grasp a relationship between article 22 to be delivered from storage 40 and accommodation case 21 for accommodating article 22.

Board work machine 10 of the present embodiment is component mounter 10c for mounting components to board 90. **In** addition, article 22 is reel 22a on which a component tape for accommodating the components is wound, and unmanned conveyance vehicle 30 conveys reel 22a in a state where reel 22a is accommodated in accommodation case 21. At this time, accommodation case 21 includes main body portion 21a and partition portion 21b provided so as to project upward at predetermined angle θ1 with respect to main body portion 21a and capable of accommodating reel 22a. Housing section 42 includes main body portion 42a and partition portion 42b provided so as to project upward at predetermined angle θ1 with respect to main body portion 42a and capable of accommodating reel 22a. In addition, angle θ1 of partition portion 21b of accommodation case 21 coincides with angle θ1 of partition portion 42b of housing section 42. Accordingly, storage 40 of the present embodiment can perform the unloading work at the time of warehousing when reel 22a is removed from accommodation case 21 and the housing work at the time of warehousing when reel 22a removed from accommodation case 21 is housed in housing section 42 by a lifting and lowering operation, a rotation operation, an advancing operation, and a retreating operation of moving device 40b. The above description can be similarly applied to the unloading work at the time of delivering when reel 22a is removed from the housing unit and the accommodating work at the time of delivering when reel 22a removed from the housing unit is accommodated in accommodation case 21.

When article 22 is mounted on unmanned conveyance vehicle 30, management device 19 transmits a conveyance command to unmanned conveyance vehicle 30. Upon receiving the conveyance command, unmanned conveyance vehicle 30 conveys article 22 to board work machine 10 specified as the conveyance destination. When multiple unmanned conveyance vehicles 30 travel through board production facility 80 and at least a part of the traveling paths are shared, management device 19 may set the traveling priority for multiple unmanned conveyance vehicles 30. The traveling priority can be set, for example, based on the priority of the board working using article 22 to be conveyed, a timing when article 22 is required, or the like.

### 1-3-5. Other

As shown in Fig. 5A, storage 40 includes display device 40e. As display device 40e, a known display device can be used, and displays various types of data so that the operator can visually recognize the data. Display device 40e displays, for example, article information and the like on article 22 housed in housing section 42 in response to an operation of the operator. Display device 40e of the present embodiment is configured by a touch panel, and display device 40e also functions as an input device for receiving various operations by the operator. For example, the operator can designate desired article 22 to be delivered from storage 40 using the touch panel (display device 40e functioning as the input device). In this case, control device 40a uses moving device 40b to move designated article 22 to opening portion 41b to be delivered.

In addition, control device 40a can memorize the positional information, warehousing and delivering information, and the storage information of article 22. The positional information indicates the housing location of article 22. The warehousing and delivering information indicates a date and time of warehousing article 22 and a date and time of delivering article 22. The storage information indicates at least one of an ambient temperature and a humidity of housing section 42. Control device 40a memorizes the positional information and the date of article 22 and time of warehousing article 22 at the time of housing article 22. Control device 40a memorizes the storage information during storage of article 22. Control device 40a memorizes the time of delivering article 22 at the time of delivering article 22.

### 1-4. Another example of unmanned conveyance vehicle 30

As shown in Fig. 11, unmanned conveyance vehicle 30 may include carriage portion 31 and pushing portion 34. Article 22 is mounted on carriage portion 31. Also in this aspect, carriage portion 31 may include supporting portion 31a, and unmanned conveyance vehicle 30 may convey article 22 in a state where article 22 is accommodated in accommodation case 21. Pushing portion 34 is swingably provided on carriage portion 31, and pushes carriage portion 31. Pushing portion 34 may take various forms as long as it can push carriage portion 31. For example, pushing portion 34 includes connecting portion 34a connected to carriage portion 31. Connecting portion 34a is formed in a convex shape and is inserted into through hole 31b of carriage portion 31. An inner diameter of through hole 31b is formed to be slightly larger than an outer diameter of connecting portion 34a. Therefore, carriage portion 31 follows pushing portion 34 while swing in accordance with the movement of pushing portion 34.

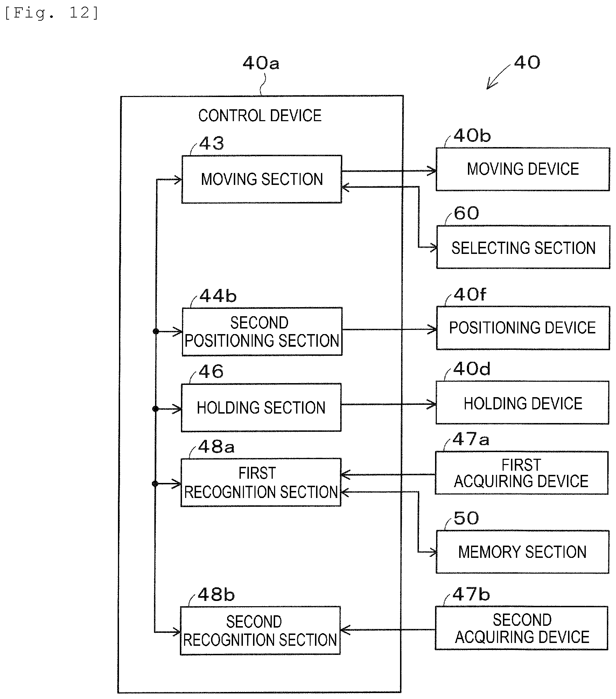

In this aspect, as shown in Fig. 12, control device 40a of storage 40, when viewed as a control block, preferably includes second positioning section 44b. In addition, storage 40 preferably includes positioning device 40f. As shown in Fig. 12, control device 40a does not include pulling section 45. Storage 40 does not include pulling device 40c. Therefore, instead of the control shown in step S11 in Fig. 8A, second positioning section 44b positions carriage portion 31 in opening portion 41a. The other configurations and control procedures are the same as those of the above-described embodiment.

Second positioning section 44b guides carriage portion 31 when carriage portion 31 enters opening portion 41a by pushing portion 34 to position carriage portion 31 at a predetermined position in opening portion 41a. Second positioning section 44b can position carriage portion 31 using, for example, positioning device 40f. Positioning device 40f can use, for example, a cylinder mechanism that is driven to expand and contract by oil pressure, air pressure, electric power, or the like. The cylinder mechanism includes at least a pair of cylinders. One of the pairs of cylinders moves in a direction indicated by arrow EC1 in Fig. 11 when positioning carriage portion 31, and the other of the pair of cylinders moves in a direction indicated by arrow EC2 in Fig. 11 when positioning carriage portion 31.

Unmanned conveyance vehicle 30 includes carriage portion 31 on which article 22 is mounted, and pushing portion 34 swingably provided on carriage portion 31 for pushing carriage portion 31. In addition, storage 40 includes second positioning section 44b that positions carriage portion 31 in opening portion 41a. Second positioning section 44b guides carriage portion 31 when carriage portion 31 enters opening portion 41a by pushing portion 34 to position carriage portion 31 at a predetermined position in opening portion 41a. Accordingly, the positioning of unmanned conveyance vehicle 30 is facilitated, so that connection between unmanned conveyance vehicle 30 and opening portion 41a is facilitated. In this aspect, storage 40 (second positioning section 44b and positioning device 40f) independently guides unmanned conveyance vehicle 30, so that unmanned conveyance vehicle 30 is connected to opening portion 41a.

### 1-5. Storage apparatus 70

Storage apparatus 70 includes unmanned conveyance vehicle 30 and storage 40. Unmanned conveyance vehicle 30 may be in the aspect described in the embodiment (the aspect including positioned portion 32 and control section 33), or may be in the above-described modified aspect (the aspect including carriage portion 31 and pushing portion 34). The same applies to storage apparatus 70 as described above in the embodiment and the modified aspect. Memory section 50 may be provided in management device 19. Selecting section 60 may be provided in management device 19.

When memory section 50 is provided in management device 19, management device 19 can collectively manage correspondence relationship between the specific information and the identification information. Similarly, when selecting section 60 is provided in management device 19, management device 19 can collectively manage the selection of articles 22 to be delivered from storage 40. In particular, when board production facility 80 includes multiple accommodation cases 21, the management of the correspondence relationship is likely to be complicated. When board production facility 80 includes multiple storages 40, the selection of articles 22 to be delivered from storage 40 is likely to be complicated. By providing memory section 50 and selecting section 60 in management device 19, the management of the correspondence relationship and the selection of article 22 can be facilitated.

### 1-6. Other

The above-described embodiment and modified aspect mainly describes an example of a case where article 22 is reel 22a. However, article 22 may be, for example, above-described feeder 22b, tray 22c, solder container 22d, the holding member, the holding member accommodation device, or the like. As shown in Fig. 2, article 22 can be accommodated in accommodation case 21 compatible with article 22. In addition, storage 40 may include a housing unit compatible with article 22, and may include a moving device compatible with article 22. In addition, the moving device of storage 40 can house accommodation case 21 in which article 22 is accommodated in the housing unit together with accommodation case 21.

### 2. Example of effects of embodiment

With storage 40, storage 40 includes opening portion 41a, housing section 42, and moving section 43. As a result, storage 40 can directly transfer article 22 between unmanned conveyance vehicle 30 and storage 40 in a state where unmanned conveyance vehicle 30 is connected to opening portion 41a, so that the work efficiency of loading and unloading work of article 22 is improved.

### Reference Signs List

10: board work machine, 10c: component mounter, 21: accommodation case, 21a and 42a: main body portion, 21b and 42b: partition portion, 22: article, 22a: reel, 23: specific code, 24: identification code, 30: unmanned conveyance vehicle, 31: carriage portion, 32: positioned portion, 33: control section, 34: pushing portion, 40: storage, 41a: opening portion, 42: housing section, 43: moving section, 44a: first positioning portion, 44b: second positioning section, 45: pulling section, 46: holding section, 47a: first acquisition device, 47b: second acquisition device, 48a: first recognition section, 48b: second recognition section, 50: memory section, 60: selecting section, 70: storage apparatus, 90: board, CP1: convex portion, RP1: concave portion, θ1: angle

## Claims

1. A storage and supply system comprising:
a storage (40), and
an unmanned conveyance vehicle (30) configured to:
convey multiple articles (22) in a state of being accommodated in an accommodation case (21), and
separate itself from the accommodation case (21) to leave it within the storage (40) so as to allow the unmanned conveyance vehicle (30) to be separated from the storage (40) and the accommodation case (21),
wherein the storage (40) comprising:
an opening portion (41a) configured to be connectable with the unmanned conveyance vehicle (30) conveying the articles (22) to a board work machine (10) for performing a predetermined board working on a board (90);
a housing section (42) configured to house the articles (22) conveyed by the unmanned conveyance vehicle (30);
a moving portion (43) configured to:
move the articles (22) to a predetermined housing section (42) at the time of warehousing the articles (22) by connecting the unmanned conveyance vehicle (30) to the opening portion (41a), and
move the articles (22) housed in the housing section (42) to the unmanned conveyance vehicle (30) connected to the opening portion (41a) at the time of delivering the articles (22); and
a holding portion (46) configured to hold the accommodation case (21) during the times of warehousing the articles (22) and delivering the articles (22) so as to allow the unmanned conveyance vehicle (30) to be separated from the storage (40).

2. The storage and supply system according to claim 1, wherein the storage (40) further includes
a first acquisition device (47a) configured to read a specific code provided in the accommodation case (21) to acquire specific information for specifying the accommodation case (21); and
a first recognition section (48a) configured to acquire, from a correspondence relationship between the specific information and identification information for identifying the articles (22), which is memorized in a memory section (50), the identification information corresponding to the specific information acquired by the first acquisition device (47a) at the time of warehousing the articles (22), and recognize the articles (22) housed in the housing section (42) based on the identification information acquired from the correspondence relationship.

3. The storage and supply system according to claim 2, wherein
the memory section (50) memorizes the correspondence relationship between the specific information acquired by the first acquisition device (47a) at the time of delivering the articles (22), and the identification information for identifying the articles (22) accommodated in the accommodation case (21).

4. The storage and supply system according to claim 1, further comprising:
a second acquisition device (47b) configured to read an identification code provided in the articles (22) to acquire identification information for identifying the articles (22); and
a second recognition section (48b) configured to recognize the articles (22) to be housed in the housing section (42) based on the identification information acquired by the second acquisition device (47b) at the time of warehousing the articles (22).

5. The storage and supply system according to any one of claims 1 to 4, wherein
the moving section (43) is configured to move the articles (22) selected by a selecting section (60) configured to select the articles (22) to be delivered from the storage (40) to the unmanned conveyance vehicle (30) in accordance with the articles (22) required by the board work machine (10), to the unmanned conveyance vehicle (30).

6. The storage and supply system according to any one of claims 1 to 5, wherein
the board work machine (10) is a component mounter (10c) configured to mount a component on the board (90),
each of the articles (22) is a reel on which a component tape configured to accommodate the component is wound,
each of the accommodation case (21) and the housing section (42) includes a main body portion (21a, 42a); and
a partition portion (21b, 42b) provided so as to project upward at a predetermined angle (θ1) with respect to the main body portion (21a, 42a) and configured to accommodate the reel, and
the angle of the partition portion (21b, 42b) of the accommodation case (21) coincides with the angle (θ1) of the partition portion (21b, 42b) of the housing section (42).

7. The storage and supply system according to any one of claims 1 to 6, wherein
the storage (40) includes a first positioning portion (44a) configured to position the unmanned conveyance vehicle (30) in the opening portion (41a), and
the unmanned conveyance vehicle (30) includes
a positioned portion (32) configured to be positioned on the first positioning portion (44a); and
a control section (33) configured to control traveling of the unmanned conveyance vehicle (30) such that the positioned portion (32) is directed toward the first positioning portion (44a).

8. The storage and supply system according to claim 7, wherein
one of the first positioning portion (44a) and the positioned portion (32) includes a convex portion (CP1) formed in a convex shape, and the other of the first positioning portion (44a) and the positioned portion (32) includes a concave portion (RP2) capable of being fitted with the convex portion (CP1) and is formed in a concave shape, and
the positioned portion (32) is positioned on the first positioning portion (44a) by fitting the convex portion (CP1) to the concave portion (RP2).

9. The storage and supply system according to claim 7 or 8, wherein
the storage (40) further includes a pulling section (45) configured to pull the unmanned conveyance vehicle (30) and assist in positioning the unmanned conveyance vehicle (30).

10. The storage and supply system according to claim 1, wherein
the unmanned conveyance vehicle (30) further includes
a carriage portion (31) configured to mount the articles (22); and
a pushing portion (34) provided swingably on the carriage portion (31) and configured to push the carriage portion (31),
the storage (40) further includes a second positioning portion (44b) configured to position the carriage portion (31) in the opening portion (41a), and
the second positioning portion (44b) guides the carriage portion (31) when the carriage portion (31) enters the opening portion (41a) by the pushing portion (34) to position the carriage portion (31) at a predetermined position of the opening portion (41a).

## Patentansprüche

1. Lagerungs- und Versorgungssystem, umfassend:
einem Speicher (40) und
einem unbemannten Transportfahrzeug (30), das konfiguriert ist, um:
mehrere Gegenstände (22) in einem Zustand, in dem sie in einem Aufnahmegehäuse (21) untergebracht sind, zu transportieren und
sich von dem Aufnahmegehäuse (21) zu trennen, um es innerhalb des Speichers (40) zu belassen, so dass das unbemannte Transportfahrzeug (30) von dem Speicher (40) und dem Aufnahmegehäuse (21) getrennt werden kann,
wobei der Speicher (40) umfasst:
einen Öffnungsabschnitt (41a), der so konfiguriert ist, dass er mit dem unbemannten Transportfahrzeug (30) verbunden werden kann, das die Gegenstände (22) zu einer Plattenbearbeitungsmaschine (10) transportiert, um eine vorbestimmte Plattenbearbeitung an einer Platte (90) durchzuführen;
einen Gehäuseabschnitt (42), der so konfiguriert ist, dass er die vom unbemannten Transportfahrzeug (30) transportierten Gegenstände (22) aufnimmt;
einen Bewegungsabschnitt (43), der so konfiguriert ist, dass er:
Bewegen der Gegenstände (22) zu einem vorbestimmten Gehäuseabschnitt (42) zum Zeitpunkt der Einlagerung der Gegenstände (22) durch Verbinden des unbemannten Transportfahrzeugs (30) mit dem Öffnungsabschnitt (41a) und
die in dem Gehäuseabschnitt (42) untergebrachten Gegenstände (22) zum Zeitpunkt der Auslieferung der Gegenstände (22) zu dem mit dem Öffnungsabschnitt (41a) verbundenen unbemannten Transportfahrzeug (30) zu bewegen; und
einen Halteabschnitt (46), der so konfiguriert ist, dass er den Aufbewahrungsbehälter (21) während der Lagerung der Gegenstände (22) und der Auslieferung der Gegenstände (22) so hält, dass das unbemannte Transportfahrzeug (30) vom Lager (40) getrennt werden kann.

2. Lagerungs- und Versorgungssystem nach Anspruch 1, wobei das Lager (40) ferner umfasst
eine erste Erfassungsvorrichtung (47a), die so konfiguriert ist, dass sie einen spezifischen Code liest, der in dem Aufnahmegehäuse (21) vorgesehen ist, um spezifische Informationen zum Bestimmen des Aufnahmegehäuses (21) zu erfassen; und
einen ersten Erkennungsabschnitt (48a), der so konfiguriert ist, dass er aus einer Zuordnungsbeziehung zwischen den spezifischen Informationen und Identifizierungsinformationen zum Identifizieren der Gegenstände (22), die in einem Speicherabschnitt (50) gespeichert sind, die Identifizierungsinformationen, die den spezifischen Informationen entsprechen, die von der ersten Erfassungsvorrichtung (47a) zum Zeitpunkt der Einlagerung der Gegenstände (22) erfasst wurden, und die in dem Gehäuseabschnitt (42) untergebrachten Artikel (22) auf der Grundlage der aus der Zuordnungsbeziehung erfassten Identifizierungsinformationen zu erkennen.

3. Lagerungs- und Versorgungssystem nach Anspruch 2, wobei
der Speicherabschnitt (50) die Zuordnungsbeziehung zwischen den spezifischen Informationen, die von der ersten Erfassungsvorrichtung (47a) zum Zeitpunkt der Auslieferung der Gegenstände (22) erfasst wurden, und den Identifizierungsinformationen zum Identifizieren der in dem Aufbewahrungsbehälter (21) untergebrachten Artikel (22) speichert.

4. Lagerungs- und Versorgungssystem nach Anspruch 1, das ferner umfasst:
eine zweite Erfassungsvorrichtung (47b), die so konfiguriert ist, dass sie einen in den Artikeln (22) vorgesehenen Identifikationscode liest, um Identifikationsinformationen zum Identifizieren der Gegenstände (22) zu erfassen; und
einen zweiten Erkennungsabschnitt (48b), der so konfiguriert ist, dass er die in dem Aufbewahrungsabschnitt (42) aufzubewahrenden Artikel (22) auf der Grundlage der von der zweiten Erfassungsvorrichtung (47b) zum Zeitpunkt der Einlagerung der Gegenstände (22) erfassten Identifizierungsinformationen erkennt.

5. Lagerungs- und Versorgungssystem nach einem der Ansprüche 1 bis 4, wobei
der Bewegungsabschnitt (43) so konfiguriert ist, dass er die Artikel (22), die von einem Auswahlabschnitt (60) ausgewählt wurden, der so konfiguriert ist, dass er die aus dem Lager (40) an das unbemannte Transportfahrzeug (30) zu liefernden Artikel (22) entsprechend den von der Plattenbearbeitungsmaschine (10) benötigten Artikeln (22) auswählt, zu dem unbemannten Transportfahrzeug (30) bewegt.

6. Lagerungs- und Versorgungssystem nach einem der Ansprüche 1 bis 5, wobei die Platinenbearbeitungsmaschine (10) eine Bauteilmontagemaschine (10c) ist, die so konfiguriert ist, dass sie ein Bauteil auf die Platine (90) montiert,
jeder der Gegenstände (22) eine Rolle ist, auf die ein Bauteilband aufgewickelt ist, das zur Aufnahme des Bauteils konfiguriert ist,
jedes der Aufnahmegehäuse (21) und der Gehäuseabschnitte (42) einen Hauptkörperabschnitt (21a, 42a) umfasst; und
ein Trennteil (21b, 42b) vorgesehen ist, das so ausgebildet ist, dass es in einem vorbestimmten Winkel (θ1) in Bezug auf den Hauptkörperteil (21a, 42a) nach oben vorsteht und zur Aufnahme der Rolle ausgebildet ist, und
der Winkel des Trennwandabschnitts (21b, 42b) des Aufnahmegehäuses (21) mit dem Winkel (θ1) des Trennwandabschnitts (21b, 42b) des Gehäuseabschnitts (42) übereinstimmt.

7. Lagerungs- und Versorgungssystem gemäß einem der Ansprüche 1 bis 6, wobei
die Speichereinrichtung (40) einen ersten Positionierungsabschnitt (44a) umfasst, der so konfiguriert ist, dass er das unbemannte Transportfahrzeug (30) in dem Öffnungsabschnitt (41a) positioniert, und
das unbemannte Transportfahrzeug (30) umfasst
einen Positionierteil (32), der so konfiguriert ist, dass er auf dem ersten Positionierteil (44a) positioniert werden kann; und
einen Steuerabschnitt (33), der so konfiguriert ist, dass er die Fahrt des unbemannten Transportfahrzeugs (30) so steuert, dass der Positionierungsabschnitt (32) auf den ersten Positionierungsabschnitt (44a) ausgerichtet ist.

8. Lagerungs- und Versorgungssystem nach Anspruch 7, wobei
einer der ersten Positionierungsabschnitte (44a) und der positionierten Abschnitte (32) einen konvexen Abschnitt (CP1) umfasst, der in einer konvexen Form ausgebildet ist, und der andere der ersten Positionierungsabschnitte (44a) und der positionierten Abschnitte (32) einen konkaven Abschnitt (RP2) umfasst, der mit dem konvexen Abschnitt (CP1) zusammenpassen kann und in einer konkaven Form ausgebildet ist, und
der positionierte Abschnitt (32) auf dem ersten Positionierungsabschnitt (44a) positioniert ist, indem der konvexe Abschnitt (CP1) in den konkaven Abschnitt (RP2) eingepasst ist.

9. Lagerungs- und Versorgungssystem nach Anspruch 7 oder 8, wobei
die Speichereinrichtung (40) ferner einen Zugabschnitt (45) umfasst, der so konfiguriert ist, dass er das unbemannte Transportfahrzeug (30) zieht und das Positionieren des unbemannten Transportfahrzeugs (30) unterstützt.

10. Lagerungs- und Versorgungssystem nach Anspruch 1, wobei
das unbemannte Transportfahrzeug (30) ferner umfasst
einen Wagenabschnitt (31), der zum Aufnehmen der Gegenstände (22) konfiguriert ist; und
einen Schiebeabschnitt (34), der schwenkbar an dem Transportabschnitt (31) vorgesehen ist und zum Schieben des Transportabschnitts (31) konfiguriert ist,
der Speicher (40) ferner einen zweiten Positionierungsabschnitt (44b) umfasst, der zum Positionieren des Wagenabschnitts (31) in dem Öffnungsabschnitt (41a) konfiguriert ist, und
der zweite Positionierungsabschnitt (44b) führt den Schlittenabschnitt (31), wenn der Schlittenabschnitt (31) durch den Schubabschnitt (34) in den Öffnungsabschnitt (41a) eintritt, um den Schlittenabschnitt (31) an einer vorbestimmten Position des Öffnungsabschnitts (41a) zu positionieren.

## Revendications

1. Système de stockage et d'approvisionnement comprenant :
un stockage (40), et
un véhicule de transport sans conducteur (30) configuré pour :
transporter plusieurs articles (22) à l'état d'être logés dans un boîtier de logement (21), et
se séparer du boîtier de logement (21) pour le laisser à l'intérieur du stockage (40) de manière à permettre au véhicule de transport sans conducteur (30) d'être séparé du stockage (40) et du boîtier de logement (21),
dans lequel le stockage (40) comprenant :
une partie d'ouverture (41a) configurée pour être connectée au véhicule de transport sans conducteur (30) transportant les articles (22) vers une machine de travail de carte (10) pour effectuer un travail de carte prédéterminé sur une carte (90) ;
une section de logement (42) configurée pour loger les articles (22) transportés par le véhicule de transport sans conducteur (30) ;
une partie de déplacement (43) configurée pour :
déplacer les articles (22) vers une section de logement (42) prédéterminée au moment de l'entreposage des articles (22) en connectant le véhicule de transport sans conducteur (30) à la partie d'ouverture (41a), et
déplacer les articles (22) logés dans la section de logement (42) vers le véhicule de transport sans conducteur (30) connecté à la partie d'ouverture (41a) au moment de la livraison des articles (22) ; et
une partie de maintien (46) configurée pour maintenir le boîtier de logement (21) pendant les périodes d'entreposage des articles (22) et de livraison des articles (22) de manière à permettre au véhicule de transport sans conducteur (30) d'être séparé du stockage (40).

2. Système de stockage et d'approvisionnement selon la revendication 1, dans lequel le stockage (40) inclut en outre
un premier dispositif d'acquisition (47a) configuré pour lire un code spécifique prévu dans le boîtier de logement (21) pour acquérir des informations spécifiques permettant de spécifier le boîtier de logement (21) ; et
une première section de reconnaissance (48a) configurée pour acquérir, à partir d'une relation de correspondance entre les informations spécifiques et les informations d'identification des articles (22), qui est mémorisée dans une section mémoire (50), les informations d'identification correspondant aux informations spécifiques acquises par le premier dispositif d'acquisition (47a) au moment de l'entreposage des articles (22), et reconnaître les articles (22) logés dans la section de logement (42) sur la base des informations d'identification acquises à partir de la relation de correspondance.

3. Système de stockage et d'approvisionnement selon la revendication 2, dans lequel
la section mémoire (50) mémorise la relation de correspondance entre les informations spécifiques acquises par le premier dispositif d'acquisition (47a) au moment de la livraison des articles (22), et les informations d'identification des articles (22) logés dans le boîtier de logement (21).

4. Système de stockage et d'approvisionnement selon la revendication 1, comprenant en outre :
un deuxième dispositif d'acquisition (47b) configuré pour lire un code d'identification prévu dans les articles (22) pour acquérir des informations d'identification permettant d'identifier les articles (22) ; et
une deuxième section de reconnaissance (48b) configurée pour reconnaître les articles (22) à loger dans la section de logement (42) sur la base des informations d'identification acquises par le deuxième dispositif d'acquisition (47b) au moment du stockage des articles (22).

5. Système de stockage et d'approvisionnement selon l'une quelconque des revendications 1 à 4, dans lequel
la section de déplacement (43) est configurée pour déplacer les articles (22) sélectionnés par une section de sélection (60) configurée pour sélectionner les articles (22) à livrer depuis le stockage (40) vers le véhicule de transport sans conducteur (30) selon les articles (22) requis par la machine de travail de carte (10), vers le véhicule de transport sans conducteur (30).

6. Système de stockage et d'approvisionnement selon l'une quelconque des revendications 1 à 5, dans lequel
la machine de travail de carte (10) est un monteur de composants (10c) configuré pour monter un composant sur la carte (90),
chacun des articles (22) est une bobine sur laquelle est enroulé un ruban de composant configuré pour recevoir le composant,
chacun du boîtier de logement (21) et de la section de logement (42) inclut une partie de corps principal (21a, 42a) ; et
une partie de cloison (21b, 42b) prévue pour faire saillie vers le haut à un angle (θ1) prédéterminé par rapport à la partie de corps principal (21a, 42a) et configurée pour accueillir la bobine, et
l'angle de la partie de cloison (21b, 42b) du boîtier de logement (21) coïncide avec l'angle (θ1) de la partie de cloison (21b, 42b) de la section de logement (42).

7. Système de stockage et d'approvisionnement selon l'une quelconque des revendications 1 à 6, dans lequel
le stockage (40) inclut une première partie de positionnement (44a) configurée pour positionner le véhicule de transport sans conducteur (30) dans la partie d'ouverture (41a), et
le véhicule de transport sans conducteur (30) inclut
une partie positionnée (32) configurée pour être positionnée sur la première partie de positionnement (44a) ; et
une section de commande (33) configurée pour commander le déplacement du véhicule de transport sans conducteur (30) de sorte que la partie positionnée (32) soit dirigée vers la première partie de positionnement (44a).

8. Système de stockage et d'approvisionnement selon la revendication 7, dans lequel
l'une de la première partie de positionnement (44a) et de la partie positionnée (32) inclut une partie convexe (CP1) de forme convexe, et l'autre de la première partie de positionnement (44a) et de la partie positionnée (32) inclut une partie concave (RP2) capable d'être emboîtée à la partie convexe (CP1) et de forme concave, et
la partie positionnée (32) est positionnée sur la première partie de positionnement (44a) en emboîtant la partie convexe (CP1) à la partie concave (RP2).

9. Système de stockage et d'approvisionnement selon la revendication 7 ou 8, dans lequel
le stockage (40) inclut en outre une section de traction (45) configurée pour tirer le véhicule de transport sans conducteur (30) et aider au positionnement du véhicule de transport sans conducteur (30).

10. Système de stockage et d'approvisionnement selon la revendication 1, dans lequel
le véhicule de transport sans conducteur (30) inclut en outre
une partie de chariot (31) configurée pour monter les articles (22) ; et
une partie de poussée (34) prévue de manière pivotante sur la partie de chariot (31) et configurée pour pousser la partie de chariot (31),
le stockage (40) inclut en outre une deuxième partie de positionnement (44b) configurée pour positionner la partie de chariot (31) dans la partie d'ouverture (41a), et
la deuxième partie de positionnement (44b) guide la partie de chariot (31) lorsque la partie de chariot (31) entre dans la partie d'ouverture (41a) par la partie de poussée (34) pour positionner la partie de chariot (31) à une position prédéterminée de la partie d'ouverture (41a).
